# EUROPÄISCHE PATENTSCHRIFT

(11) **EP 2 886 366 B1**
(45) Veröffentlichungstag und Bekanntmachung des Hinweises auf die Patenterteilung: **31.10.2018**
(21) Anmeldenummer: 13198764.6
(22) Anmeldetag: 20.12.2013
(51) Int. Cl.: B44B 5/02, B22F 3/105, B29C 67/00, B41C 1/00, B44C 3/02, G03F 7/00

(54) **VERFAHREN ZUR HERSTELLUNG EINES DRUCK- ODER PRÄGEZYLINDERS ODER EINER DRUCK- ODER PRÄGEHÜLSE**
METHOD FOR THE PREPARATION OF A PRINTING OR EMBOSSING CYLINDER OR A PRINTING OR EMBOSSING SLEEVE
PROCÉDÉ DE FABRICATION D'UN CYLINDRE D'IMPRESSION OU DE GAUFRAGE OU D'UNE DOUILLE D'IMPRESSION OU DE GAUFRAGE

(43) Veröffentlichungstag der Anmeldung: 24.06.2015
(73) Patentinhaber: Mayr-Melnhof Karton AG, 1041 Wien (AT)
(72) Erfinder: Theis, Uwe, 54317 Riveris (DE); Höhnen, Roland, 54533 Bettenfeld (DE)
(74) Vertreter: Hofstetter, Schurack & Partner

(56) Entgegenhaltungen:
- EP-A1- 2 537 675
- EP-A2- 1 449 648
- WO-A1-97/19776
- WO-A1-2013/060375
- DE-A1- 10 024 618
- DE-A1- 10 159 084
- US-A1- 2013 255 346

## Beschreibung

Die vorliegende Erfindung betrifft ein Verfahren zur Herstellung eines Druck- und/oder Prägezylinders oder einer auf einem Träger anzuordnenden Druck- und/oder Prägehülse umfassend jeweils eine strukturiert ausgebildete Zylindermantelaußenfläche zur Erzeugung einer Druck- und/oder Prägestruktur auf einem Material oder einer Materialbahn.

Druck- oder Prägezylinder sowie auf einem Träger anzuordnende Druck- oder Prägehülsen werden für eine Vielzahl von Druckverfahren benötigt und verwendet. Beispielhaft sind hier Hochdruckverfahren für Zylinderdruckpressen und Rotationsmaschinen sowie der Flexo- und Tiefdruck genannt. Neben dem Bedrucken unterschiedlichster Materialien, wie zum Beispiel Papier, Karton oder Kunststofffolien, können diese Materialien auch geprägt werden. Über entsprechende Prägezylinder oder an Trägern angeordneten Prägehülsen werden auf dem zu prägenden Material Oberflächenstrukturen unterschiedlichster Art aufgebracht. Derartige Prägestrukturen werden zum Beispiel auf Tapeten oder Zigarettenschachteln wie auch anderen Verpackungen aus Karton oder Kunststoff aufgebracht. Im Verpackungsbereich soll durch die zusätzliche Prägung der Verpackungsoberfläche eine Veredelung der entsprechenden Verpackung erreicht werden. Übliche Prägeverfahren sind das so genannte Embossing/Debossing und die Blindprägung. Bei dem Embossing/Debossing-Verfahren werden jeweils zwei mit ihren Oberflächenstrukturen zueinander passende Zylinder, nämlich die so genannte Patrize und Matrize angefertigt, wobei das zu prägende Material zwischen den beiden Zylindern hindurchbewegt wird. Bei der so genannten Blindprägung prägt ein Prägezylinder das mit der Struktur zu versehende Material gegen einen glatten Zylinder.

Die Herstellung derartiger Druck- und/oder Prägezylinder oder entsprechender Druck- und/oder Prägehülsen ist aus dem Stand der Technik bekannt. So beschreibt zum Beispiel die EP 1 837 202 B1 ein Verfahren zur Herstellung eines nahtlosen Prägezylinders, wobei mittels eines Laser- oder Elektronenstrahlsystems auf einen vorbereiteten Zylinder 3D-Strukturen eingearbeitet werden und diese energetische Einarbeitung durch direktes Entfernen und/oder Verdampfen von Metall, Keramik oder sonstiger Werkstoffe mithilfe des Laser- oder Elektronenstrahlsystems erfolgt. Zwar kann hier eine nahtlose Zylinderaußenfläche erzielt werden, was für die genannten Druck- und Prägeverfahren von Vorteil ist. Allerdings ist die nachträgliche Bearbeitung der Zylinderoberfläche mittels eines Laser- oder Elektronenstrahlsystems sehr aufwändig und teuer. Aus der DE 101 59 084 A1, der EP 2 537 675 A1 und der EP 1 449 648 A1 sind Verfahren zur Herstellung eines Druck- und/oder Prägezylinders oder einer auf einem Träger anzuordnenden Druck- und/oder Prägehülse umfassend jeweils eine strukturiert ausgebildete Zylindermantelaußenfläche bekannt wie sie im Oberbegriff des Anspruch 1 beschrieben sind.

Es ist Aufgabe der vorliegenden Erfindung ein gattungsgemäßes Verfahren zur Herstellung eines Druck- und/oder Prägezylinders oder einer auf einem Träger anzuordnenden Druck- und/oder Prägehülse bereitzustellen, welches eine schnelle und ökonomische Fertigung von Druck- und/oder Prägezylindern oder Druck- und/oder Prägehülsen mit einer nahtlosen Zylinderaußenfläche ermöglicht. Eine weitere Aufgabe der Erfindung ist es, einen Druck- und/oder Prägezylinder oder eine Druck- und/oder Prägehülse umfassend jeweils eine strukturiert ausgebildete Zylindermantelaußenfläche bereitzustellen, welche schnell und ökonomisch hergestellt werden können.

Die Aufgaben werden erfindungsgemäß durch ein Verfahren mit den Merkmalen des Patentanspruchs 1 sowie durch einen Druck- und/oder Prägezylinder oder eine Druck- und/oder Prägehülse gemäß Patentanspruch 13 gelöst. Vorteilhafte Ausgestaltungen mit zweckmäßigen Weiterbildungen der Erfindung sind in den Unteransprüchen angegeben.
Ein erfindungsgemäßes Verfahren zur Herstellung eines Druck- und/oder Prägezylinders oder einer auf einem Träger anzuordnenden Druck- und/oder Prägehülse umfassend jeweils eine strukturiert ausgebildete Zylindermantelaußenfläche zur Erzeugung einer Druck- und/oder Prägestruktur auf einem Material oder einer Materialbahn ist dadurch gekennzeichnet, dass die Zylindermantelaußenfläche mittels eines generativen Fertigungsverfahrens hergestellt wird. Unter Zylindermantelaußenfläche wird dabei die dem zu bedruckenden oder zu prägenden Material zugewandte Oberfläche des Druck- und/oder Prägezylinders oder der Druck- und/oder Prägehülse verstanden. Durch die Verwendung eines generativen Fertigungsverfahrens ist eine schnelle und ökonomische Fertigung von Druck- und/oder Prägezylindern oder Druck- und/oder Prägehülsen mit einer nahtlosen Zylinderaußenfläche möglich. Zudem ist der Druck- und/oder Prägezylinder oder die auf einem Träger anzuordnende Druck- und/oder Prägehülse in ihrer Gesamtheit mittels des generativen Fertigungsverfahrens hergestellt. Dies bedeutet, dass es erfindungsgemäß möglich ist, nicht nur die das Druck- und/oder Prägebild bestimmende Zylindermantelaußenfläche mit entsprechenden Druck- und/oder Prägedaten zu versehen, sondern auch den zylinderförmigen Körper des Druck- und/oder Prägezylinders generativ in einem einzigen Verfahrensschritt herzustellen. Der Druck- und/oder Prägezylinder oder die Druck- und/oder Prägehülse wird erfindungsgemäß daher einstückig mit der strukturierten Zylindermantelaußenfläche ausgebildet und generativ hergestellt. Da die Anzahl an Fertigungsschritten minimiert werden kann, ist das erfindungsgemäße Verfahren besonders schnell und kostengünstig durchführbar. Zudem besteht die Möglichkeit, sehr schnell und flexibel auf mögliche Änderungen im Druck- und/oder Prägedesign reagieren zu können.
In vorteilhaften Ausgestaltungen des erfindungsgemäßen Verfahrens ist das generative Herstellungsverfahren ein Stereolithographieverfahren, ein Digital Light Processing-Verfahren, ein 3D-Druckverfahren, ein Schmelzschichtungsverfahren, ein Multi Jet Modeling-Verfahren, ein selektives Lasersinter- oder selektives Laserschmelzverfahren, ein Elektronenstrahlschmelzverfahren oder eine Kombination dieser Verfahren. Die Verwendung einzelner oder einer Kombination dieser Fertigungsverfahren richtet sich nach dem herzustellenden Produkt. In einer besonders vorteilhaften Ausgestaltung der Erfindung werden auch bei der Verwendung unterschiedlicher Materialien beziehungsweise unterschiedlicher generativer Fertigungsverfahren diese so ausgewählt, dass unterschiedliche Elemente des Druck- und/oder Prägezylinders oder der Druck- und/oder Prägehülse in einem generativen Fertigungsschritt gefertigt werden können. Wird als generatives Fertigungsverfahren ein Stereolithographieverfahren verwendet, so kann als Werkstoff insbesondere mindestens ein flüssiges, photosensitives Kunststoffmaterial und/oder ein Kunstharz und/oder ein photosensitiver Lack verwendet werden. Dabei kann das erfindungsgemäße Verfahren folgende Schritte umfassen: a) Bereitstellung von digitalisierten Daten, welche den dreidimensionalen Aufbau des Druck- und/oder Prägezylinders und/oder der Druck- und/oder Prägehülse und der strukturierten Zylindermantelaußenfläche darstellen; b) schichtweises und lokales Aushärten des photosensitiven Kunststoffmaterials und/oder des photosensitiven Lacks zum Zuführen von Energie im Bereich einer Aufbau- und Aushärtzone; c) schichtweises Absenken des entstehenden Zwischenprodukts um eine vordefinierte Schichtdicke; und d) Wiederholen der vorhergehenden Schritte b) bis c) bis zur Fertigstellung des Druck- und/oder Prägezylinders oder der Druck- und/oder Prägehülse und der Zylindermantelaußenfläche. Dabei wird üblicherweise im Verfahrensschritt b) Laserenergie zugeführt. Des Weiteren besteht die Möglichkeit, dass nach dem Verfahrensschritt d) ein weiterer Aushärtungsprozess mittels UV-Strahlung durchgeführt wird.
In einer vorteilhaften Ausgestaltung des erfindungsgemäßen Verfahrens kann als Werkstoff für ein 3D-Druckverfahren mindestens ein UV-härtender Lack und/oder mindestens eine UV-härtende Tinte verwendet werden. Dieses alternative erfindungsgemäße Verfahren kann wiederum folgende Schritte umfassen: a) Bereitstellung von digitalisierten Daten, welche den dreidimensionalen Aufbau des Druck- und/oder Prägezylinders oder der Druck- und/oder Prägehülse und die strukturierte Zylindermantelaußenfläche darstellen; b) schichtweises und lokales Aushärten des mindestens einen UV-härtenden Lacks und/oder der mindestens einen UV-härtenden Tinte durch Zuführen von UV-Licht im Bereich einer Aufbau- und Aushärtzone; und c) Wiederholen des vorhergehenden Schritts b) bis zur Fertigstellung des Druck- und/oder Prägezylinders oder der Druck- und/oder Prägehülse und der Zylindermantelaußenfläche. Die Verwendung eines derartigen 3D-Druckverfahrens bietet insbesondere für die Ausgestaltung der Zylindermantelaußenfläche, das heißt für das Aufbringen von insbesondere Bild- und/oder Prägeinformationen Vorteile.

In weiteren vorteilhaften Ausgestaltungen des erfindungsgemäßen Verfahrens wird als Werkstoff für das selektive Lasersinter- oder selektive Laserschmelzverfahren mindestens ein Kunststoff, Kunstharz, Metall, eine Metalllegierung oder Keramik oder eine Kombination dieser Werkstoffe in Pulverform verwendet. Hierbei können insbesondere Elemente der Druck- und/oder Prägezylinder beziehungsweise Druck- und/oder Prägehülsen, die zum Beispiel aus Aluminium oder einer Aluminiumlegierung bestehen, generativ gefertigt werden. Bei der Verwendung des selektiven Lasersinter- oder selektiven Laserschmelzverfahrens können erfindungsgemäß folgende Schritte ausgeführt werden: a) Bereitstellung von digitalisierten Daten, welche den dreidimensionalen Aufbau des Druck- und/oder Prägezylinders oder der Druck- und/oder Prägehülse und/die strukturierte Zylindermantelaußenfläche darstellen; b) schichtweises Auftragen von mindestens einem pulverförmigen Bauteilwerkstoff auf eine Bauteilplattform im Bereich einer Aufbau- und Fügezone; c) schichtweises und lokales Verschmelzen und/oder Versintern des Bauteilwerkstoffs durch Zuführen von Energie im Bereich der Aufbau- und Fügezone; d) schichtweises Absenken der Bauteilplattform um eine vordefinierte Schichtdicke; und e) Wiederholen der Schritte b) bis d) bis zur Fertigstellung des Druck- und/oder Prägezylinders oder der Druck- und/oder Prägehülse und der Zylindermantelaußenfläche. Dabei wird üblicherweise im Verfahrensschritt c) Laserenergie zugeführt.

Die im Vorhergehenden beschriebenen generativen Fertigungsverfahren stellen nur beispielhaft die Möglichkeiten der erfindungsgemäßen generativen Fertigung von Druck- und/oder Prägezylindern oder von Druck- und/oder Prägehülsen oder von Teilen dieser Zylinder oder Hülsen dar. Weitere generative Fertigungsverfahren sind denkbar. Bei den generativ hergestellten Strukturen der Zylindermantelaußenfläche handelt es sich zum Beispiel um Druck- und/oder Prägeraster, die üblicherweise punktförmig aufgebaut sind. Des Weiteren besteht die Möglichkeit, dass zumindest einzelne Bereiche der Zylindermantelaußenfläche gehärtet werden. Dies kann zum Beispiel durch ein Verchromen dieser Bereiche erfolgen, so dass diese Bereiche vor Erosion, vorzeitiger Abnutzung oder Verunreinigungen geschützt sind. Des Weiteren besteht die Möglichkeit, dass die Oberfläche der Zylindermantelaußenfläche nach Fertigstellung zumindest teilweise auch mit anderen vorteilhaften Materialien beschichtet wird.

Die in den Zylindermantelaußenflächen erfindungsgemäß hergestellten Strukturen können als so genannte 2D- oder 3D-Strukturen ausgebildet sein. Im Bereich der Druck- und Prägetechnik werden dabei unter 2D-Strukturen derartige verstanden, die nur flächenmoduliert ausgeprägt sind. Unter eigentlichen 3D-Strukturen werden dagegen Strukturen verstanden, die tatsächlich deutlich volumenbeschreibende Strukturen entstehen lassen. Es kann auch von einstufigen, das heißt zweidimensionalen Prägungen, und mehrstufigen Prägungen, das heißt dreidimensionalen Prägungen, gesprochen werden.

Die Erfindung betrifft weiterhin einen Druck- und/oder Prägezylinder oder eine Druck- und/oder Prägehülse umfassend jeweils eine strukturiert ausgebildete Zylindermantelaußenfläche zur Erzeugung einer Druck- und/oder Prägestruktur auf einem Material oder einer Materialbahn hergestellt nach dem im Vorhergehenden beschriebenen erfindungsgemäßen Verfahren. Derartige Druck- und/oder Prägezylinder und/oder Druck- und/oder Prägehülsen sind schnell und ökonomisch herstellbar. Die entsprechend bereitgestellten digitalisierten Daten, welche den dreidimensionalen Aufbau des Druck- und/oder Prägezylinders und/oder der Druck- und/oder Prägehülse und einer strukturiert ausgebildeten Zylindermantelaußenfläche dieser Elemente darstellen, können ohne Weiteres einer entsprechenden generativen Fertigungsvorrichtung zugeführt werden. Die generative Fertigungsvorrichtung fertigt dann nach den übermittelten Daten den entsprechenden Druck- und Prägezylinder oder die Druck- und/oder Prägehülse mit der entsprechenden Zylindermantelaußenfläche. Da somit die Anzahl an Fertigungsschritten minimiert werden kann, ist das erfindungsgemäße Verfahren und die entsprechenden erfindungsgemäßen Druck- und/oder Prägezylinder, Druck- und/oder Prägehülsen und die entsprechenden Zylindermantelaußenflächen dieser Elemente besonders schnell und kostengünstig herstellbar. Dies gilt auch bei der Verwendung unterschiedlicher Materialien zur Herstellung der vorgenannten Produkte. Zudem besteht die Möglichkeit, sehr schnell und flexibel auf mögliche Änderungen im Druck- und/oder Prägedesign reagieren zu können.

## Patentansprüche

1. Verfahren zur Herstellung eines Druck- und/oder Prägezylinders oder einer auf einem Träger anzuordnenden Druck- und/oder Prägehülse umfassend jeweils eine strukturiert ausgebildete Zylindermantelaußenfläche zur Erzeugung einer Druck- und/oder Prägestruktur auf einem Material oder einer Materialbahn, wobei die Zylindermantelaußenfläche mittels eines generativen Fertigungsverfahrens hergestellt wird, **dadurch gekennzeichnet, dass** der Druck- und/oder Prägezylinder oder die Druck- und/oder Prägehülse einstückig mit der strukturierten Zylindermantelaußenfläche ausgebildet und generativ hergestellt werden.

2. Verfahren nach einem der vorhergehenden Ansprüche, **dadurch gekennzeichnet, dass** das generative Fertigungsverfahren ein Stereolithographieverfahren, ein Digital Light Processing-Verfahren, ein 3D-Druckverfahren, ein Schmelzschichtungsverfahren, ein Multi Jet Modeling-Verfahren, ein selektives Lasersinter- oder selektives Laserschmelzverfahren, ein Elektronenstrahlschmelzverfahren oder eine Kombination dieser Verfahren ist.

3. Verfahren nach Anspruch 2, **dadurch gekennzeichnet, dass** als Werkstoff für das Stereolithographieverfahren mindestens ein flüssiges, photosensitives Kunststoffmaterial und/oder ein Kunstharz und/oder ein photosensitiver Lack verwendet wird.

4. Verfahren nach Anspruch 3, **dadurch gekennzeichnet, dass** das Verfahren zur Herstellung des Druck- und/oder Prägezylinders oder der Druck- und/oder Prägehülse und der strukturierten Zylindermantelaußenfläche folgende Schritte umfasst:
a) Bereitstellung von digitalisierten Daten, welche den dreidimensionalen Aufbau des Druck- und/oder Prägezylinders oder der Druck- und/oder Prägehülse und die strukturierte Zylindermantelaußenfläche darstellen;
b) Schichtweises und lokales Aushärten des photosensitiven Kunststoffmaterials und/oder des photosensitiven Lacks durch Zuführen von Energie im Bereich einer Aufbau- und Aushärtzone;
c) Schichtweises Absenken des entstehenden Zwischenprodukts um eine vordefinierte Schichtdicke; und
d) Wiederholen der vorhergehenden Schritte b) und c) bis zur Fertigstellung des Druck- und/oder Prägezylinders oder der Druck- und/oder Prägehülse und der Zylindermantelaußenfläche.

5. Verfahren nach Anspruch 4, **dadurch gekennzeichnet, dass** im Verfahrensschritt b) Laserenergie zugeführt wird.

6. Verfahren nach Anspruch 4 oder 5, **dadurch gekennzeichnet, dass** nach dem Verfahrensschritt d) ein weiterer Aushärtungsprozess mittels UV-Strahlung durchgeführt wird.

7. Verfahren nach Anspruch 2, **dadurch gekennzeichnet, dass** als Werkstoff für das 3D-Druckverfahren mindestens ein UV-härtender Lack und/oder mindestens eine UV-härtende Tinte verwendet wird.

8. Verfahren nach Anspruch 7, **dadurch gekennzeichnet, dass** das Verfahren zur Herstellung des Druck- und/oder Prägezylinders oder der Druck- und/oder Prägehülse und der strukturierten Zylindermantelaußenfläche folgende Schritte umfasst:
a) Bereitstellung von digitalisierten Daten welche den dreidimensionalen Aufbau des Druck- oder Prägezylinders oder der Prägehülse und die strukturierte Zylindermantelaußenfläche darstellen;
b) Schichtweises und lokales Aushärten des mindestens einen UV-härtenden Lacks und/oder der mindestens einen UV-härtenden Tinte durch Zuführen von UV-Licht im Bereich einer Aufbau- und Aushärtzone; und
c) Wiederholen des vorhergehenden Schritts b) bis zur Fertigstellung des Druck- und/oder Prägezylinders oder der Druck- und/oder Prägehülse und der Zylindermantelaußenfläche.

9. Verfahren nach Anspruch 2, **dadurch gekennzeichnet, dass** als Werkstoff für das selektive Lasersinter- oder selektive Laserschmelzverfahren mindestens ein Kunststoff, Kunstharz, Metall, Metalllegierung oder Keramik oder eine Kombination dieser Werkstoffe in Pulverform verwendet wird.

10. Verfahren nach Anspruch 9, **dadurch gekennzeichnet, dass** das Verfahren zur Herstellung des Druck- und/oder Prägezylinders oder der Druck- und/oder Prägehülse und der strukturierten Zylindermantelaußenfläche folgende Schritte umfasst:
a) Bereitstellung von digitalisierten Daten, welche den dreidimensionalen Aufbau des Druck- und/oder Prägezylinders oder der Druck- und/oder Prägehülse und die strukturierte Zylindermantelaußenfläche darstellen;
b) Schichtweises Auftragen von mindestens einem pulverförmigen Bauteilwerkstoff auf eine Bauteilplattform im Bereich einer Aufbau- und Fügezone;
c) Schichtweises und lokales Verschmelzen und/oder Versintern des Bauteilwerkstoffs durch Zuführen von Energie im Bereich der Aufbau- und Fügezone;
d) Schichtweises Absenken der Bauteilplattform um eine vordefinierte Schichtdicke; und
e) Wiederholen der Schritte b) bis d) bis zur Fertigstellung des Druck- und/oder Prägezylinders oder der Druck- und/oder Prägehülse und der Zylindermantelaußenfläche.

11. Verfahren nach Anspruch 10, **dadurch gekennzeichnet, dass** im Verfahrensschritt c) Laserenergie zugeführt wird.

12. Verfahren nach einem der vorhergehenden Ansprüche, **dadurch gekennzeichnet, dass** die Oberfläche der Zylindermantelaußenfläche nach Fertigstellung zumindest teilweise beschichtet wird.

13. Druck- und/oder Prägezylinder oder Druck- und/oder Prägehülse umfassend jeweils eine strukturiert ausgebildete Zylindermantelaußenfläche zur Erzeugung einer Druck- und/oder Prägestruktur auf einem Material oder einer Materialbahn hergestellt nach einem Verfahren gemäß einem der Ansprüche 1 bis 12.

## Claims

1. Method for producing a printing and/or stamping cylinder or a printing and/or stamping sleeve to be arranged on a support each including a structured formed cylinder jacket exterior surface for generating a printing and/or stamping structure on a material or a material web, wherein the cylinder jacket exterior surface is produced by means of a generative manufacturing method, **characterized in that** the printing and/or stamping cylinder or the printing and/or stamping sleeve is formed integrally with the structured cylinder jacket exterior surface and generatively produced.

2. Method according to any one of the preceding claims, **characterized in that** the generative manufacturing method is a stereolithography method, a digital light processing method, a 3D printing method, a fused deposition modeling method, a multi jet modeling method, a selective laser sintering or selective laser fusing method, an electron beam fusing method or a combination of these methods.

3. Method according to claim 2, **characterized in that** at least one liquid, photosensitive plastic material and/or a synthetic resin and/or a photosensitive varnish are used as the substance for the stereolithography method.

4. Method according to claim 3, **characterized in that** the method for producing the printing and/or stamping cylinder or the printing and/or stamping sleeve and the structured cylinder jacket exterior surface includes the following steps:
a) providing digitized data representing the three-dimensional construction of the printing and/or stamping cylinder or the printing and/or stamping sleeve and the structured cylinder jacket exterior surface;
b) locally setting the photosensitive plastic material and/or the photosensitive varnish in layers by supplying energy in the area of a construction and setting zone;
c) lowering the arising intermediate product in layers by a predefined layer thickness; and
d) repeating the preceding steps b) and c) until completion of the printing and/or stamping cylinder or the printing and/or stamping sleeve and the cylinder jacket exterior surface.

5. Method according to claim 4, **characterized in that** laser energy is supplied in the method step b).

6. Method according to claim 4 or 5, **characterized in that** a further setting process is performed by means of UV radiation after method step d).

7. Method according to claim 2, **characterized in that** at least one UV setting varnish and/or at least one UV setting ink are used as the substance for the 3D printing method.

8. Method according to claim 7, **characterized in that** the method for producing the printing and/or stamping cylinder or the printing and/or stamping sleeve and the structured cylinder jacket exterior surface includes the following steps:
a) providing digitized data representing the three-dimensional construction of the printing or stamping cylinder or the stamping sleeve and the structured cylinder jacket exterior surface;
b) locally setting the at least one UV setting varnish and/or the at least one UV setting ink in layers by supplying UV light in the area of a construction and setting zone; and
c) repeating the preceding step b) until completion of the printing and/or stamping cylinder or the printing and/or stamping sleeve and the cylinder jacket exterior surface.

9. Method according to claim 2, **characterized in that** at least one plastic, synthetic resin, metal, metal alloy or ceramic or a combination of these substances in powder form is used as the substance for the selective laser sintering or selective laser fusing method.

10. Method according to claim 9, **characterized in that** the method for producing the printing and/or stamping cylinder or the printing and/or stamping sleeve and the structured cylinder jacket exterior surface includes the following steps:
a) providing digitized data representing the three-dimensional construction of the printing and/or stamping cylinder or the printing and/or stamping sleeve and the structured cylinder jacket exterior surface;
b) applying at least one powdery component substance in layers to a component platform in the area of a construction and joining zone;
c) locally fusing and/or sintering the component substance in layers by supplying energy in the area of the construction and joining zone;
d) lowering the component platform in layers by a predefined layer thickness; and
e) repeating the steps b) to d) until completion of the printing and/or stamping cylinder or the printing and/or stamping sleeve and the cylinder jacket exterior surface.

11. Method according to claim 10, **characterized in that** laser energy is supplied in the method step c).

12. Method according to any one of the preceding claims, **characterized in that** the surface of the cylinder jacket exterior surface is at least partially coated after completion.

13. Printing and/or stamping cylinder or printing and/or stamping sleeve each including a structured formed cylinder jacket exterior surface for generating a printing and/or stamping structure on a material or a material web produced according to a method according to any one of claims 1 to 12.

## Revendications

1. Procédé de fabrication d'un cylindre d'impression et / ou d'estampage ou d'un manchon d'impression et / ou d'estampage, à agencer sur un support, comprenant respectivement une surface extérieure de la chemise du cylindre, constituée de manière structurée, destinée à produire une structure d'impression et / ou d'estampage sur un matériau ou une bande de matériau, la surface extérieure de la chemise du cylindre étant fabriquée au moyen d'un procédé génératif de fabrication,
**caractérisé en ce que**
le cylindre d'impression et / ou d'estampage ou le manchon d'impression et / ou d'estampage sont constitués et fabriqués de manière générative d'un seul tenant avec la surface extérieure structurée de la chemise du cylindre.

2. Procédé selon l'une des revendications précédentes,
**caractérisé en ce que**
le procédé génératif de fabrication est un procédé stéréolithographique, un procédé de traitement numérique de la lumière, un procédé d'impression 3D, un procédé de stratification de lit en fusion, un procédé de modelage à jets multiples, un procédé de frittage sélectif par laser ou de fusion sélective par laser, un procédé de fusion par faisceau d'électrons ou une combinaison de ces procédés.

3. Procédé selon la revendication 2,
**caractérisé en ce**
**qu'**au moins un matériau plastique liquide, photosensible et / ou une résine synthétique et / ou une peinture photosensible est utilisé(e) comme matériau pour le procédé stéréolithographique.

4. Procédé selon la revendication 3,
**caractérisé en ce que**
le procédé de fabrication du cylindre d'impression et / ou d'estampage ou du manchon d'impression et / ou d'estampage et de la surface extérieure structurée de la chemise du cylindre comprend les étapes suivantes :
a) mise à disposition de données numérisées, qui représentent la configuration tridimensionnelle du cylindre d'impression et / ou d'estampage ou du manchon d'impression et / ou d'estampage et la surface extérieure structurée de la chemise du cylindre ;
b) durcissement par couches successives et local du matériau plastique photosensible et / ou de la peinture photosensible par apport d'énergie dans le secteur d'une zone de configuration et de durcissement ;
c) abaissement par couches successives du produit intermédiaire résultant d'une épaisseur de couche prédéfinie et
d) répétition des étapes b) et c) précédentes jusqu'à l'achèvement du cylindre d'impression et / ou d'estampage ou du manchon d'impression et / ou d'estampage et de la surface extérieure de la chemise du cylindre.

5. Procédé selon la revendication 4,
**caractérisé en ce**
**qu'**au cours de l'étape de procédé b), de l'énergie laser est apportée.

6. Procédé selon la revendication 4 ou 5,
**caractérisé en ce**
**qu'**après l'étape de procédé d), un autre processus de durcissement est exécuté au moyen d'un rayonnement UV.

7. Procédé selon la revendication 2,
**caractérisé en ce**
**qu'**au moins une peinture durcissant aux UV et / ou au moins une encre durcissant aux UV est utilisé(e) comme matériau pour le procédé d'impression 3D.

8. Procédé selon la revendication 7,
**caractérisé en ce que**
le procédé de fabrication du cylindre d'impression et / ou d'estampage ou du manchon d'impression et / ou d'estampage et de la surface extérieure structurée de la chemise du cylindre comprend les étapes suivantes :
a) mise à disposition de données numérisées, qui représentent la configuration tridimensionnelle du cylindre d'impression et / ou d'estampage ou du manchon d'estampage et la surface extérieure structurée de la chemise du cylindre ;
b) durcissement par couches successives et local de la au moins une peinture durcissant aux UV et / ou de la au moins une encre durcissant aux UV par apport de lumière UV dans le secteur d'une zone de configuration et de durcissement et
c) répétition de l'étape précédente b) jusqu'à l'achèvement du cylindre d'impression et / ou d'estampage ou du manchon d'impression et de la surface extérieure de la chemise du cylindre.

9. Procédé selon la revendication 2,
**caractérisé en ce**
**qu'**au moins un matériau plastique, une résine synthétique, du métal, un alliage métallique ou de la céramique ou une combinaison de ces matériaux est utilisé(e) sous forme de poudre comme matériau pour le procédé sélectif de frittage au laser ou le procédé sélectif de fusion au laser.

10. Procédé selon la revendication 9,
**caractérisé en ce que**
le procédé de fabrication du cylindre d'impression et / ou d'estampage ou du manchon d'impression et / ou d'estampage et de la surface extérieure structurée de la chemise du cylindre comprend les étapes suivantes :
a) mise à disposition de données numérisées, qui représentent la configuration tridimensionnelle du cylindre d'impression et / ou d'estampage ou du manchon d'impression et / ou d'estampage et la surface extérieure structurée de la chemise du cylindre ;
b) dépôt par couches successives d'au moins un matériau de base pulvérulent sur une plate-forme de composant dans le secteur d'une zone de configuration et de jonction ;
c) fusion par couches successives et locale et / ou frittage du matériau de base par apport d'énergie dans le secteur de la zone de configuration et de jonction ;
d) abaissement par couches successives de la plate-forme de composant d'une épaisseur de couche prédéfinie et
e) répétition des étapes b) à d) jusqu'à l'achèvement du cylindre d'impression et / ou d'estampage ou du manchon d'impression et / ou d'estampage et de la surface extérieure de la chemise du cylindre.

11. Procédé selon la revendication 10,
**caractérisé en ce que**
de l'énergie laser est apportée au cours de l'étape de procédé c).

12. Procédé selon l'une des revendications précédentes,
**caractérisé en ce que**
la superficie de la surface extérieure de la chemise du cylindre est revêtue au moins partiellement après achèvement.

13. Cylindre d'impression et / ou d'estampage et / ou manchon d'impression et / ou d'estampage, comprenant respectivement une surface extérieure, constituée de manière structurée, de la chemise du cylindre, pour la production d'une structure d'impression et / ou d'estampage sur un matériau ou une bande de matériau, fabriqué selon un procédé suivant l'une des revendications 1 à 12.
